# EUROPEAN PATENT APPLICATION

(11) **EP 2 402 994 A1**
(43) Date of publication of application: **04.01.2012**
(21) Application number: 11172021.5
(22) Date of filing: 29.06.2011
(51) Int. Cl.: H01L 27/142, H01L 31/18

(54) **Method and system for forming photovoltaic cell and a photovoltaic cell**

(30) Priority: 01.07.2010 US 828421
(71) Applicant: PrimeStar Solar, Inc, Arvada, CO 80004 (US)
(72) Inventor: Frey, Jonathan Mack, Arvada, CO 80004 (US)
(74) Representative: Szary, Anne Catherine

(57) **Abstract**

Disclosed are a photovoltaic cell (107), a method of forming the photovoltaic cell (107), and a system for forming the photovoltaic cell (107). The photovoltaic cell (107) includes a plurality of layers, at least one scribe (503) disposed within the plurality of layers, and sidewalls (510) delineating the scribe (503) from the plurality of layers. At least a portion of the sidewalls (510) includes material properties substantially consistent with the plurality of layers.

## Description

### FIELD OF THE INVENTION

The present invention is directed to photovoltaic cells and methods and systems for forming photovoltaic cells. More specifically, the present invention is directed to methods, systems, and photovoltaic cells with a top-hat profile for selective removal of one or more of a plurality of layers.

### BACKGROUND OF THE INVENTION

Energy demand is constantly increasing. As the energy demand increases, sources alternative to fossil fuel energy sources increase in importance. One such alternative energy source is solar energy. Generally, solar energy is produced by converting radiation (for example, sunlight) into electricity which may be stored or transmitted through electrical power grids.

A laser scribing system may be used in a process of scribing monolithic integration of photovoltaic modules for producing solar energy. Conventional beam profiles include Gaussian beam profiles and may generate substantial heat and/or result in large heat affected zones (HAZ) in the scribe. The HAZ results in undesirable material alterations or damage in the areas near the scribe due to exposure to beam fluence that is insufficient to remove the material. To provide desirable scribing, larger Gaussian profile beams are used to produce the scribes. The larger Gaussian profile beams may result in larger areas of the photovoltaic cells being either scribed or heat affected.

The utilization of large Gaussian profile beams affects larger areas of the photovoltaic modules resulting in the requirement of additional material between temperature-sensitive portions of the photovoltaic cell. The additional material may decrease efficiency and/or performance, and result in increased costs. Large heat affected zones also increase the risk of failure of a photovoltaic cell by increasing the chance of shorting and/or increasing the chance of material being adversely modified.

A photovoltaic cell, a method of forming the photovoltaic cell, and a system for forming the photovoltaic cell, wherein the method, system, and photovoltaic cell have a top-hat profile beam for selective removal of one or more of a plurality of layers, thereby reducing or eliminating material modifications, such as heat affected zones, would be desirable in the field.

### BRIEF DESCRIPTION OF THE INVENTION

In an exemplary embodiment, a photovoltaic cell includes a plurality of layers, a scribe disposed within the plurality of layers, and sidewalls delineating the scribe from the plurality of layers. In the embodiment, at least a portion of the sidewalls includes material properties substantially consistent with the plurality of layers.

In another exemplary embodiment, a method of forming a photovoltaic cell includes providing a plurality of layers and directing energy from a laser to the plurality of layers and selectively removing one or more of the plurality of layers to form a scribe. In the embodiment, the scribe is delineated from the plurality of layers by sidewalls, and at least a portion of the sidewalls includes material properties substantially consistent with the plurality of layers.

In another exemplary embodiment, a system for forming a photovoltaic cell includes a photovoltaic cell positioning mechanism, a laser positioning mechanism, and a laser. The photovoltaic cell positioning mechanism is configured for positioning a plurality of layers of the photovoltaic cell. The laser positioning mechanism is configured for directing energy from a laser to the plurality of layers to form a scribe by selective removal of one or more of the plurality of layers. In the embodiment, the scribe is delineated from the plurality of layers by sidewalls, and at least a portion of the sidewalls includes material properties substantially consistent with the plurality of layers.

### BRIEF DESCRIPTION OF THE DRAWINGS

FIG. 1 shows a thin film module mounted on a base according to the disclosure.
FIG. 2 is a diagram of a layer system making up cells of a module according to the disclosure.
FIG. 3 is a process flow diagram for an exemplary process for forming a module according to the disclosure.
FIG. 4 shows an enlarged area 400 of the thin film module of FIG. 1.
FIG. 5 shows a sectional view taken in direction 5-5 of FIG. 4.
FIG. 6 is a process flow diagram for an exemplary process for forming an interconnection according to the disclosure.
FIG. 7 is a schematic view of a system for forming scribes.

Wherever possible, the same reference numbers will be used throughout the drawings to represent the same parts.

### DETAILED DESCRIPTION OF THE INVENTION

Provided is a photovoltaic cell, a method of forming the photovoltaic cell, and a system for forming the photovoltaic cell. Embodiments of the method, system, and photovoltaic cell involve a top-hat profile for selective removal of one or more of a plurality of layers, thereby reducing or eliminating material modifications, such as heat affected zones.

Embodiments of the present disclosure may include uniform removal of material (for example, through ablation and/or vaporization), improved control of scribe side-walls, improved control of heat affected zones, and/or reduced cell defects due to scribing.

In the disclosure, when a layer is being described as "adjacent", "on" or "over" another layer or substrate, it is to be understood that the layer can either be directly in contact or that another layer or feature can intervene. In addition, "dead area" includes an area across the PV module that does not produce electricity when exposed to light. For example a dead area may include an area having no material that produces electricity or may include electricity producing layers that are electrically isolated. Conversely, "active area" includes an area across the PV module that produces electricity when exposed to light and is connectable to a load. When a layer or material is described as "transparent", it is to be understood that a transparent film includes materials that are fully or partially transparent to light at some or all wavelengths found in natural sunlight. When a layer or material is described as "electrically conductive" or "conductive" or is a "conductor" it is to be understood that the material permits the flow of electricity with or without electrical resistance. When a layer or material is described as "electrically insulative", "insulative" or is an "insulator" it is to be understood that the material impedes or prevents the flow of electricity. "Reduced", "reducing", "reduction" and other grammatical variations thereof refer to chemical reduction of a material wherein a gain of electrons or a decrease in oxidation state by a molecule, atom or ion takes place. In particular, reduction may include the chemical removal of oxygen from an oxide to form a metallic or partially metallic material. "Modifying", "modify" and other grammatical variations thereof with respect to layers, articles and materials refer to a change, such as a chemical change, in the material resulting in properties that are different than the original material.

One embodiment of the disclosure includes a method for converting a transparent conductive layer, typically a transparent conductive oxide layer (TCO), in the dead area of a PV module to a higher conductivity metal. The conversion process may include a chemical reduction process that removes oxygen from the TCO. The method through which the TCO is converted is through the alleviation of oxygen in the films when heated by laser in the presence of an oxygen-attracting gas such as hydrogen, a forming gas or carbon monoxide.

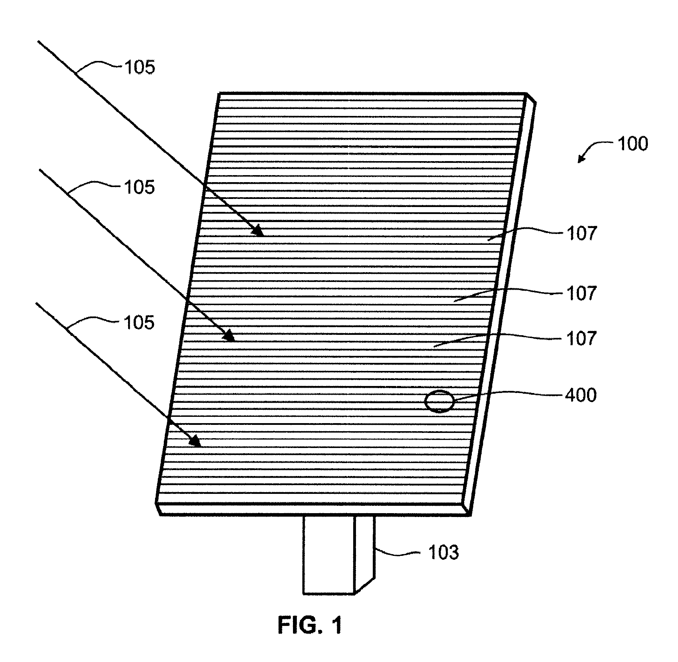

FIG. 1 shows a thin film PV module 100 mounted on a base 103. The PV module is arranged to receive light 105. The PV module is divided into a plurality of cells 107 that are arranged in series. The cells 107 are divided by spaces, non-conductive material and/or other structures separating circuits. For example, cells 107 may be isolated from each other by scribes formed by laser scribing. When the PV module 100 is exposed to light 105, electricity is produced. The disclosure is not limited to the arrangement shown and may include other mounting arrangements and/or cells 107. For example, the cells 107 may be oriented along the long dimension of module 100 instead of the short dimension of module 100. One embodiment of the disclosure includes a thin film CdTe solar photovoltaic (PV) module. Such modules are used to produce solar electricity for numerous applications, for example, large ground-mounted systems and rooftop systems on commercial and residential buildings. As shown and described in greater detail below, area 400 is an area of the PV module including several cells 107.

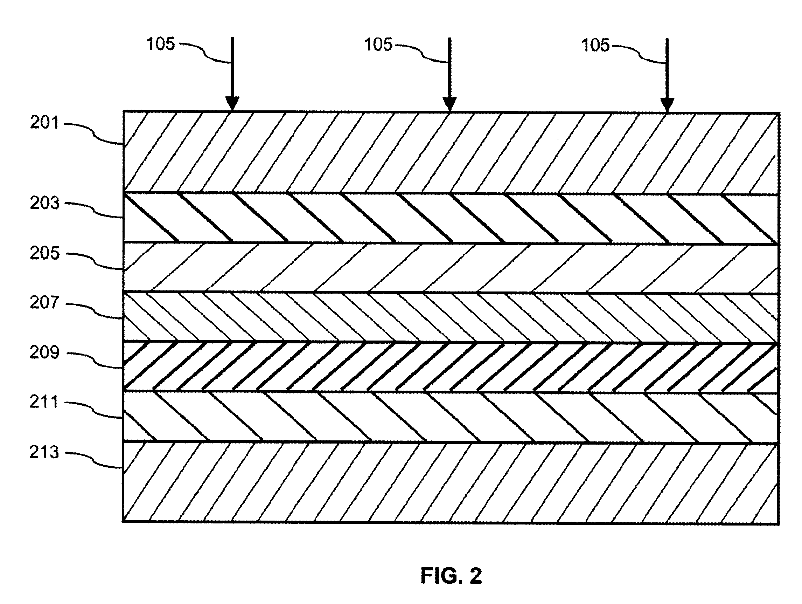

FIG. 2 is a diagram of the layer system forming cells 107 of PV module 100. The layers of cell 107 include a superstrate 201, a first conductive layer 203, a buffer layer 205, a first semiconductor layer 207, a second semiconductor layer 209, a second conductive layer 211 and an encapsulating glass 213. The layers of the cell 107 are arranged to generate and conduct electricity in a usable form when exposed to light 105.

The superstrate 201 is a sheet of high transmission glass onto which thin films are grown. The superstrate 201 receives light 105 (see e.g., FIG. 1) prior to the underlying layers. Superstrate 201 may be a high-transmission, low-iron float glass or any other suitable glass material having a high transmission rate for light 105. In another embodiment, the superstrate 201 may also be a high transmission borosilicate glass.

After the light 105 passes through superstrate 201, at least a portion of the light 105 passes through first conductive layer 203. First conductive layer 203 may be a transparent conductive oxide (TCO), which permits transmission of light 105 with little or no absorption. The first conductive layer 203 is also electrically conductive, which permits electrical conduction to provide the series arrangement of cells 107.

Other suitable first conductive layers 203 may include fluorine-doped tin oxide, aluminum-doped zinc oxide, indium tin oxide, doped indium oxide, zinc or cadmium doped tin oxide, copper aluminum oxides or another compound of cadmium tin oxide (such as CdSn0₃). First conductive layer 203 may permit passage of light 105 through to the semiconductor layers (e.g., first semiconductor layer 207 and second semiconductor layer 209) while also functioning as an ohmic electrode to transport photogenerated charge carriers away from the light absorbing material.

A buffer layer 205 is adjacent to first conductive layer 203. Buffer layer 205 is more electrically resistive and protects the layers of cell 107 from chemical interactions from the glass and/or interactions which might be incurred from subsequent processing. Inclusion of buffer layer 205 reduces or prevents electrical or other losses that may take place across cell 107 and across module 100. Suitable materials for buffer layer 205 may include tin oxide containing materials, such as zinc doped tin oxide, a mixture of zinc and tin oxides (for example zinc tin oxide having 0.5 to 33 atomic % Zn), zinc stannate, gallium oxide, aluminum oxide, silicon oxide, indium oxide, cadmium oxide and any other suitable barrier material having more electrical resistivity than first conductive layer 203 and the capability of protecting the layers of the cell 107 from interactions from the glass or interactions from subsequent processing. In addition, the inclusion of buffer layer 205 permits the formation of a first semiconductor layer 207 which permits photon passage while maintaining a high quality junction capable of generating electricity. In certain embodiments, buffer layer 205 may be omitted or substituted by another material or layer. In one embodiment, buffer layer 205 includes a combination of ZnO and SnO₂. As shown in FIG. 2, first semiconductor layer 207 is adjacent to buffer layer 205 and receives light 105 subsequent to superstrate 201, first conductive layer 203 and buffer layer 205. First semiconductor layer 207 includes a wide bandgap n-type semiconductor material. Suitable semiconductor material for first semiconductor layer 207 includes, but is not limited to CdS, Sn0₂, CdO, ZnO, AnSe, GaN, In₂0₂, CdSnO, ZnS, CdZnS or other suitable n-type semiconductor material. First semiconductor layer 207 may be formed by chemical bath deposition or by sputtering.

First semiconductor layer 207 forms the junction with second semiconductor layer 209 to create the photovoltaic effect in cell 107, allowing electricity to be generated from light 105. Second semiconductor layer 209 may include Cd, CdTe or other p-type semiconductor material. When second semiconductor layer 209 is provided with first semiconductor layer 207 a photovoltaic effect results when exposed to light 105. As shown in FIG. 2, second semiconductor layer 209 is adjacent to first semiconductor layer 207. A second conductive layer 211 is adjacent to the second semiconductor layer 209 and provides an electrically conductive material that is capable of conducting electricity formed from the combination of the first semiconductor layer 207 and second semiconductor layer 209 when exposed to light 105. Although FIG. 2 shows an arrangement of two layers for first semiconductor layer 207 and second semiconductor layer 209, any number of layers, including interstitial interfacial layers, may be utilized to provide the photovoltaic effect.

Second conductive layer 211 may be fabricated from any suitable conductive material and combinations thereof. For example, suitable materials include materials including, but not limited to, graphite, metallic silver, nickel, copper, aluminum, titanium, palladium, chrome, molybdenum alloys of metallic silver, nickel, copper, aluminum, titanium, palladium, chrome, and molybdenum and any combination thereof. In one embodiment, second conductive layer 209 may be a combination of graphite, nickel and aluminum alloys.

An encapsulating glass 213 may be adhered adjacent to second conductive layer 211. Encapsulating glass 213 may be a rigid structure suitable for use with the thin films of cell 107. Encapsulating glass 213 may be the same material as superstrate 201 or may be different. In addition, although not shown in FIG. 2, encapsulating glass 213 may include openings or structures to permit wiring and/or connection to cell 107.

Module 100 and individual cells 107 may include other layers and structures not shown in FIG. 2. For example, superstrate 201 and/or encapsulating glass 213 may include a barrier coating or other structure in order to reduce or prevent diffusion of impurities into the layers. In addition, encapsulating glass 213 may include an adherent layer to adhere encapsulating glass 213 to the layers. Additional structures that may be present in module 100 and/or cells 107 include scribes, bussing structures, external wiring, and various conventional components useful with thin film and/or PV structures.

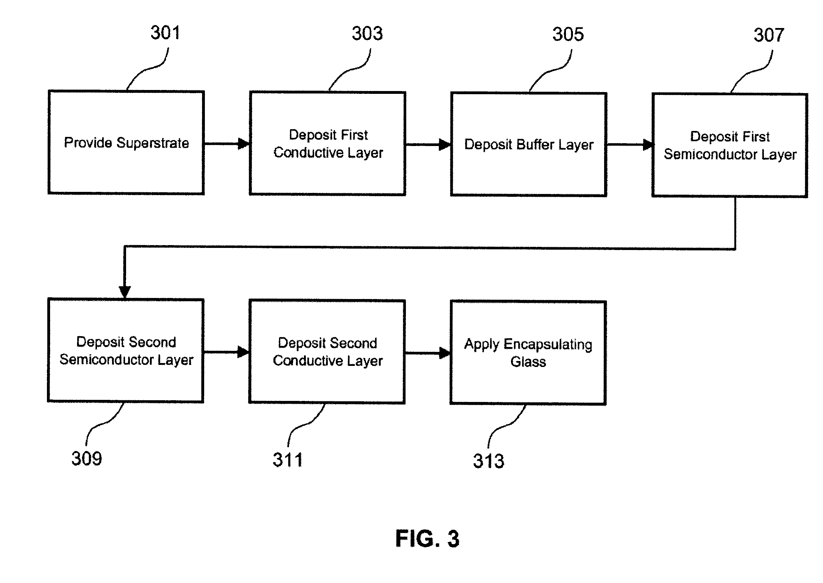

FIG. 3 shows a process flow diagram for an exemplary process for forming module 100. The process includes the formation of a thin film stack forming cell 107, wherein the films or layers are formed on superstrate 201 (shown from the top down in FIG. 2).

As shown in the flow diagram of FIG. 3, superstrate 201 is provided (box 301). Superstrate 201 may be fabricated from any suitable material capable of receiving thin films for use as photovoltaic cells 107 and sufficiently transparent to allow transmission of light 105.

Subsequent to providing superstrate 201, first conductive layer 203 is deposited onto superstrate 201 (box 303). First conductive layer 203 is electrically conductive, which permits electrical conduction to provide the series arrangement of cells 107. Other suitable first conductive layers 203 may include fluorine-doped tin oxide, aluminum-doped zinc oxide, indium tin oxide, doped indium oxide, zinc or cadmium doped tin oxide, copper aluminum oxides or another compound of cadmium tin oxide (such as CdSnO₃). First conductive layer 203 can be formed, for example by direct current (DC) or radio frequency (RF) sputtering. Cadmium stannate can alternately be prepared using cadmium acetate and tin (II) chloride precursors by spray pyrolysis.

Once first conductive layer 203 is applied, buffer layer 205 may be applied to first conductive layer 203 (box 305). In one embodiment, buffer layer 205 may be formed, for example, by sputtering. In one example, buffer layer 205 may be formed by sputtering from a hot-pressed target containing, for example, primarily Sn and 1-22% Zn by weight or stoichiometric amounts of about 67 mol % Sn0₂ and about 33 mol % ZnO onto first conductive layer 203. When deposited by sputtering, the zinc tin oxide material for buffer layer 205 may be substantially amorphous. Buffer layer 205 may have a wide optical bandgap, for example about 3.3 eV or more, in order to permit the transmission of light 105.

First semiconductor layer 207 is deposited on buffer layer 205 (box 307). In one embodiment, first semiconductor layer 207 may be formed, for example, by chemical bath deposition or sputtering. One suitable material for use as first semiconductor layer 207 is CdS. First semiconductor layer 207 forms the junction with second semiconductor layer 209 to create the photovoltaic effect in cell 107, allowing it to generate electricity from light 105.

After the formation of first semiconductor layer 207, second semiconductor layer 209 is deposited on first semiconductor layer 207 (box 309). Second semiconductor layer 209 may include Cd, CdTe or other p-type semiconductor material. Second semiconductor layer 209 may be deposited by diffusive transport deposit, sputtering or other suitable deposition method for depositing p-type semiconductor thin film material.

Subsequent to the formation of the second semiconductor layer 209, second conductive layer 211 is formed (box 311). Second conductive layer 211 may be fabricated from any suitable conductive material. Second conductive layer 211 may be formed by sputtering, electrodeposition, screen printing, physical vapor deposition (PVD), chemical vapor deposition (CVD) or spraying. In one embodiment, second conductive layer 211 is a combination of graphite that is screen printed onto the surface and nickel and aluminum alloy that is sputtered thereon.

All the sputtering steps described above may be magnetron sputtering at ambient temperature under highly pure atmospheres. For example, a zinc tin oxide buffer layer 205 may be formed by DC sputtering in a substantially pure 0₂ environment at a pressure of 1 to 3 millitorr. For example, a CdS first semiconductor layer 207 may be formed by DC sputtering. However, other deposition processes may be used, including higher temperature sputtering, electrodeposition, screen printing, physical vapor deposition (PVD), chemical vapor deposition (CVD) or spraying. In addition, the processing may be provided in a continuous line or may be a series of batch operations. When the process is a continuous process, the sputtering or deposition chambers are individually isolated and brought to coating conditions during each coating cycle, then repeated.

Once second conductive layer 211 is formed, encapsulating glass 213 is adhered to second conductive layer 211 (box 313). Encapsulating glass 213 may be a rigid material suitable for use with thin film structures and may be the same material or different material than superstrate 201. Encapsulating glass 213 may be adhered to second conductive layer 211 using any suitable method. For example, encapsulating glass 213 may be adhered to second conductive layer 211 using an adhesive or other bonding composition.

Although not shown in FIG. 3, other processing steps may be included in the process for forming module 100 and cells 107. For example, cleaning, etching, doping, dielectric or other selective insulative material deposition, formation of interstitial layers, scribing, heat treatments, and wiring may also be utilized. For example, wiring and/or bussing devices may be provided to complete the PV circuit (i.e., cells 107 in series arrangement) and to provide connectivity of the PV circuit to a load or other external device.

Scribing may be utilized to form the interconnections between the layers and to isolate cells 107 and/or layers of the thin film stack. Scribing may be accomplished using any known technique for scribing and/or interconnecting the thin film layers. In one embodiment, scribing is accomplished using a laser directed at one or more layers from one or more directions. One or more laser scribes may be utilized to selectively remove thin film layers and to provide interconnectivity and/or isolation of cells 107. In one embodiment, the scribes and layer deposition are accomplished to interconnect and/or isolate cells 107 to provide a PV circuit having cells 107 in a series of electrical arrangements.

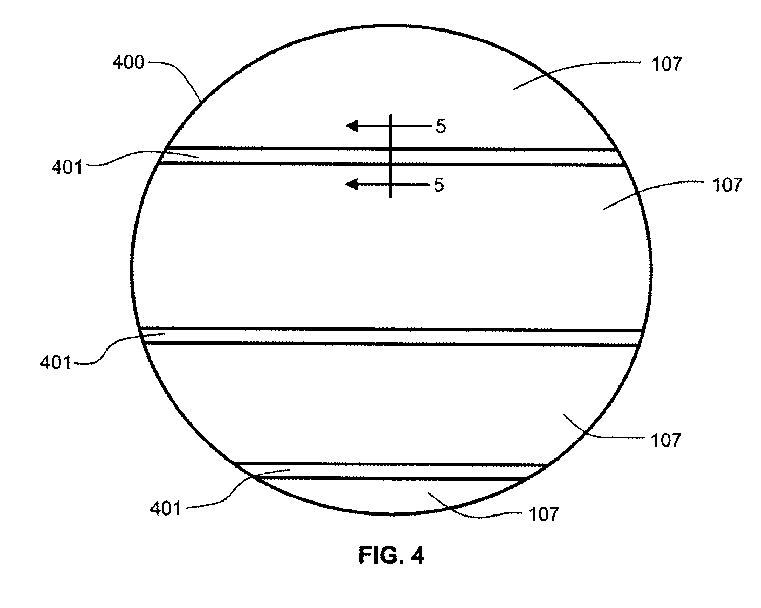

FIG. 4 shows an enlarged area 400 from FIG. 1. As shown in FIG. 4, cells are divided by interconnections 401. The interconnections 401 may suitable structures for forming the electrical interconnection between cells 107. Suitable structures may include spacing or scribes, dielectric material, insulating material, wiring, conductive material or other suitable material for forming the electrical connection between cells 107.

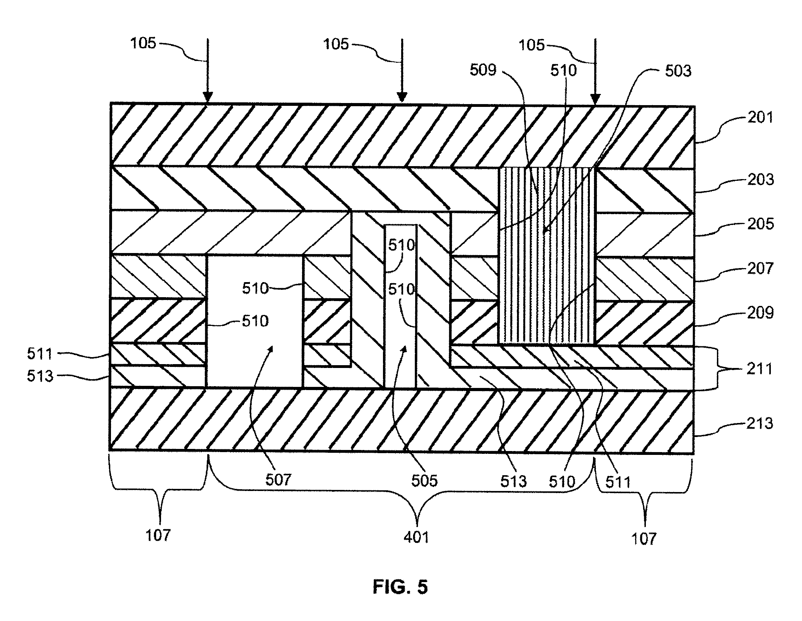

FIG. 5 illustrates a side view of an exemplary film stack for interconnection 401 taken in direction 5-5 of FIG. 4. As shown in FIG. 5, the interconnection includes structures formed between cells 107. As shown in FIG. 5 interconnection 401 includes a first scribe 503, a second scribe 505 and a third scribe 507. First scribe 503, second scribe 505 and third scribe 507 of interconnection 401 are formed during the formation of the cell 107 (see method of FIG. 3). Scribes 503, 505, 507 may be delineated by sidewalls 510 extending through the one or more layers of cell 107.

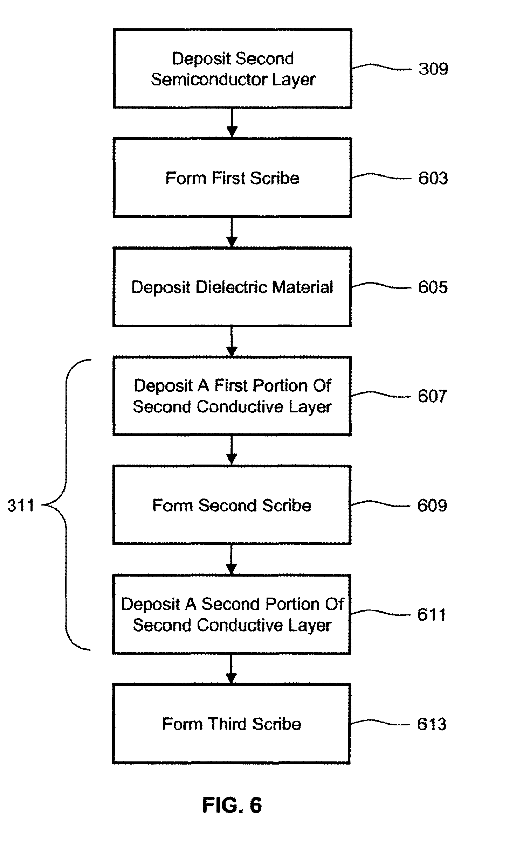

FIG. 6 includes a flowchart illustrating an exemplary method for forming interconnection 401. The method includes depositing second semiconductor layer 209 (box 309), as shown and described with respect to box 309 of FIG. 3. Specifically, first scribe 503 is formed subsequent to the deposition of the second semiconductor layer 209 (box 603) and may be formed by directing energy (for example, a beam) from a laser (as an energy source) through superstrate 201 to selectively remove the layers present thereon. In some embodiments, the laser is a laser capable of generating a beam having a substantially uniform fluence across the beam. The beam profile may be a top-hat or other profile having substantially uniform fluence. The uniform fluence may be generated using any known method for forming uniform fluence beams including, but not limited to optics, mechanical arrangements, or other laser structures. To provide electrical isolation, the first scribe 503 is filled with dielectric material 509 (box 605).

The method for forming interconnection 401 further includes formation of the second scribe 505 during the deposition of the second conductor layer 211 (box 311 of FIG. 3). This step includes depositing a first portion 511 (see FIG. 5) of second conductor layer 211 (box 607). First portion 511 may include any suitable conductive material. Suitable first portion 511 may include, for example, graphite. After first portion 511 is formed, second scribe 505 may be formed by directing a beam from a laser through superstrate 201 to selectively remove the layers present thereon (box 609). The energy source may be any suitable laser and may include the same or different laser utilized to form first scribe 503. Subsequent to formation of second scribe 505, a second portion 513 of second conductive layer 211 is provided (box 611). Second portion 513 may be any suitable conductive material and may include, for example, metal alloys, such as Ni and Al containing alloys. For example, in one embodiment, a first portion 511 containing graphite layer is provided prior to second scribe 505 and a second portion 513 a metal layer is provided after second scribe 505 is formed. In addition to providing second portion 513 to cell 107, second portion 513 (see FIG. 5) also is deposited onto surfaces formed by second scribe 505. Since second portion 513 of second conductive layer 211 is electrically conductive, the second portion electrically connects first conductive layer 203 and buffer layer 205 to second conductive layer 211. This connection (upon isolation with third scribe 507, see below) places the cells 107 into a series arrangement.

Third scribe 507 is formed subsequent to the deposition of second conductive layer 211 (box 613). Third scribe 507 may be formed by directing a beam from a laser onto the layers from the direction opposite superstrate 201 to selectively remove the layers present thereon. The laser may be any suitable laser and may include the same or different type of laser utilized to form first scribe 503. Third scribe 507 severs second conductive layer 211 and first semiconductor layer 207 and second semiconductor layer 209, but permits buffer layer 205 and first conductive layer 203 to remain (see e.g., FIG. 5). The arrangement of module 100 remaining after third scribe 507 is a series arrangement of cells 107.

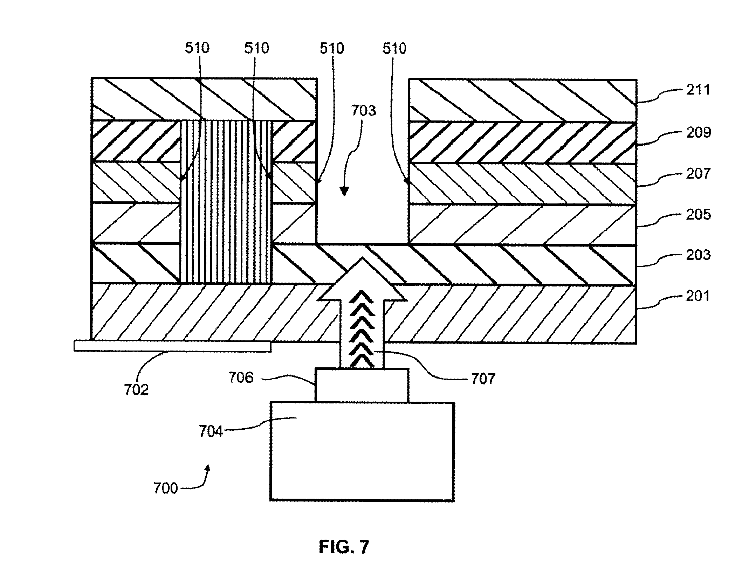

Referring to FIG. 7, a system 700 for forming cell 107 may include a photovoltaic cell positioning mechanism 702, a laser positioning mechanism 704, and laser 706. The device forming one or more scribes 703 (which may be scribe 503, 505, or 507) may be laser 706. Laser 706 directs a beam 707 to selectively remove one or more layers of cell 107. In selectively removing the one or more layers of cell 107, laser 706 forms scribe(s) 703 delineated by sidewalls 510. When a beam having large profile is used for forming scribe(s) 703, sidewalls 510 may be materially altered and be part of a heat affected zone, which may be undesirable. For example, the material alteration may include physical alterations (such as recrystallization) and/or mechanical alterations (such as hardening). The region of material alteration may form the heat affected zone.

Laser 706 may generate beam 707 having a top-hat profile and a near-uniform fluence (energy density) within a circular disk. The fluence may be formed by diffractive optical elements from a Gaussian beam. The intensity of beam 707 from laser 706 may be adjusted with optical amplifiers (not shown). Thus, laser 706 may provide a uniform and intense beam resulting in a reduced or eliminated heat affected zone. In contrast, a purely Gaussian beam profile generates substantial heat and results in a large heat affected zone (HAZ). For example, a shorter wavelength may be used for producing a higher energy beam 707. The higher energy beam may therefore have a decreased heat affected zone. In addition, using the shorter wavelength may provide improved spatial resolution. In one embodiment, the top-hat beam profile may have a wavelength from about 100 nm to about 10.6 micrometers.

According to an exemplary embodiment, when laser 706 is used for forming scribe(s) 703, at least a portion of sidewalls 510 may include material properties substantially consistent with the one or more layers of cell 107. For example, physical properties (such as crystal structure) and/or mechanical properties (such as hardness) may be substantially maintained. In one embodiment, substantially every portion of sidewalls 510 includes material properties substantially consistent with the one or more layers of cell 107. The substantial consistency of the material properties may include physical and/or mechanical properties. For example, the substantial consistency may relate to whether the material has been vaporized, whether the material has melted, whether the material has chemically intermixed, and/or whether the material has welded layers together. The substantial consistency may, therefore, reduce or eliminate the heat affected zone in cell 107. In one embodiment, sidewalls 510 and/or cell 107 may be substantially devoid of a heat affected zone.

In one embodiment, the selective removal of the one or more of the plurality of layers of cell 107 may be initiated by a predetermined wavelength and/or fluence, the predetermined wavelength and/or fluence being provided by laser 706. Exemplary wavelength ranges include, but are not limited to about 266 nm, about 355 nm, about 532 nm, about 1064 nm, or about 1070 nm. In one embodiment, the wavelength may be between about 100 nm and bout 10.6 micrometers. For example, a deep UV range to far IR range provided by a CO₂ laser may provide energy of a predetermined wavelength.

Photovoltaic cell positioning mechanism 702 of system 700 may be configured for positioning a plurality of layers of the cell 107. Photovoltaic cell positioning mechanism 702 may adjust and/or maintain one or more predetermined distances between cell 107, portions of cell 107, and/or laser(s) 706. In an exemplary embodiment, photovoltaic cell positioning mechanism 702 may be a mechanical alignment mechanism with vision recognition enabling automated alignment. In another embodiment, photovoltaic cell positioning mechanism 702 may be any suitable mechanism for securing cell 107 and maintaining a relative position with laser 706.

Laser positioning mechanism 704 of system 700 may be configured for directing beam 707 from laser 706 to the plurality of layers to form one or more scribes 703 by selective removal of one or more of the plurality of layers. Laser positioning mechanism 704 may include one or more lasers 706. Laser positioning mechanism 704 secures the one or more lasers 706. In one embodiment, laser positioning mechanism 704 adjusts and/or maintains relative position between laser 706, cell 107, and/or one or more additional lasers.

In one embodiment, system 700 and/or laser 706 may form first scribe 503 extending through first conductive layer 203, buffer layer 205, first semiconductor layer 207, and second semiconductor layer 209. In the embodiment, use of laser 706 results in the heat affected zone being reduced or eliminated. The heat affected zone associated with the formation of first scribe 503 extends to less than a predetermined point. For example, the predetermined point may be quantifiable (for example, 10 microns from the scribe) and/or the predetermined point may be relative (for example, other scribes, or sidewalls 510). In one embodiment, the predetermined wavelength is at about 1070 nm and the heat affected zone extends about 10 micrometers to about 20 micrometers. In another embodiment, the predetermined wavelength is at about 532 nm and the heat affected zone extends about 5 micrometers to about 10 micrometers. In another embodiment, the predetermined wavelength is at about 266 nm and the heat affected zone extends about 1 micrometers to about 2 micrometers.

Additionally or alternatively, material properties of sidewalls 510 may be substantially consistent with first conductive layer 203, buffer layer 205, first semiconductor layer 207, second semiconductor layer 209, or combinations thereof. For example, at a depth corresponding to first conductive layer 203, sidewalls 510 of first scribe 503 may have material properties substantially consistent with first conductive layer 203. At a depth corresponding to buffer layer 205, sidewalls 510 may have material properties substantially consistent with buffer layer 205. At a depth corresponding to first semiconductor layer 207, sidewalls 510 may have material properties substantially consistent with first semiconductor layer 207. At a depth corresponding to second semiconductor layer 209, sidewalls 510 may have material properties substantially consistent with second semiconductor layer 209.

In one embodiment, system 700 and/or laser 706 may form second scribe 505 extending through buffer layer 205, first semiconductor layer 207, second semiconductor layer 209, and second conductive layer 211. The heat affected zone associated with the formation of second scribe 505 extends to less than a predetermined point. For example, the predetermined point may be quantifiable and/or the predetermined point may be relative (for example, other scribes, or sidewalls 510). Additionally or alternatively, material properties of sidewalls 510 may be substantially consistent with buffer layer 205, first semiconductor layer 207, second semiconductor layer 209, second conductive layer 211, or combinations thereof. For example, at a depth corresponding to buffer layer 205, sidewalls 510 of scribe 505 may have material properties substantially consistent with buffer layer 205. At a depth corresponding to first semiconductor layer 207, sidewalls 510 may have material properties substantially consistent with first semiconductor layer 207. At a depth corresponding to second semiconductor layer 209, sidewalls 510 may have material properties substantially consistent with second semiconductor layer 209. At a depth corresponding to second conductive layer 211, sidewalls 510 may have material properties substantially consistent with second conductive layer 211.

In one embodiment, system 700 and/or laser 706 may form third scribe 507 extending through first semiconductor layer 207 and second semiconductor layer 209. In the embodiment, use of laser 706 results in the heat affected zone being reduced or eliminated. For example, in one embodiment, the heat affected zone associated with formation of third scribe 507 does not include first conductive layer 203. In a further embodiment, the heat affected zone associated with formation of third scribe 507 does not include buffer 205. In another embodiment, the heat affected zone associated with the formation of scribe 507 does not include the region surrounding second scribe 505. In further embodiments, any suitable combination of first scribe 503, second scribe 505, and/or third scribe 507 may be formed by laser 706.

In one embodiment, system 700 and/or laser 706 may form third scribe 507 extending through first semiconductor layer 207 and second semiconductor layer 209. The heat affected zone associated with the formation of third scribe 507 may extend to less than a predetermined point. For example, the predetermined point may be quantifiable and/or the predetermined point may be relative (for example, other scribes, or sidewalls 510). Additionally or alternatively, material properties of sidewalls 510 of scribe 507 may be substantially consistent with first semiconductor layer 207, second semiconductor layer 209, or combinations thereof. For example, at a depth corresponding to first semiconductor layer 207, sidewalls 510 may have material properties substantially consistent with first semiconductor layer 207. At a depth corresponding to second semiconductor layer 209, sidewalls 510 may have material properties substantially consistent with second semiconductor layer 209.

While the invention has been described with reference to a preferred embodiment, it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment disclosed as the best mode contemplated for carrying out this invention, but that the invention will include all embodiments falling within the scope of the appended claims.

For completeness, various aspects of the invention are now set out in the following numbered clauses:
1. A photovoltaic cell, comprising:
   a plurality of layers;
   a scribe disposed within the plurality of layers; and
   sidewalls delineating the scribe from the plurality of layers;
   wherein at least a portion of the sidewalls includes material properties substantially consistent with the plurality of layers.
2. The cell of clause 1, wherein the plurality of layers includes a superstrate, a first conductive layer, a buffer layer, a first semiconductor layer, a second semiconductor layer, a second conductive layer, and an encapsulating glass.
3. The cell of clause 2, wherein substantially all portions of the sidewalls include material properties substantially consistent with the plurality of layers.
4. The cell of clause 2, wherein the material properties include hardness.
5. The cell of clause 2, wherein the material properties include crystal structure.
6. The cell of clause 2, wherein the scribe extends through the first semiconductor layer and the second semiconductor layer.
7. The cell of clause 2, wherein the scribe extends through the buffer layer, the first semiconductor layer, the second semiconductor layer, and the second conductive layer.
8. The cell of clause 1, wherein the a portion of the sidewalls has been exposed to a predetermined wavelength, the predetermined wavelength being provided by the laser.
9. The cell of clause 1, wherein a heat affected zone extends to less than a predetermined point, the predetermined point being 20 microns from the scribe.
10. The cell of clause 1, wherein a heat affected zone extends to less than a predetermined point, the predetermined point being the sidewalls.
11. The cell of clause 1, wherein the material properties include hardness.
12. The cell of clause 1, wherein the material properties include crystal structure.
13. A method of forming a photovoltaic cell, the method comprising:
   providing a plurality of layers; and
   directing energy from a laser to the plurality of layers and selectively removing one or more of the plurality of layers to form a scribe;
      wherein the scribe is delineated from the plurality of layers by sidewalls,
      wherein at least a portion of the sidewalls includes material properties substantially consistent with the plurality of layers.
14. The method of clause 13, wherein substantially all portions of the sidewalls include material properties substantially consistent with the plurality of layers.
15. The method of clause 13, wherein the removal of the one or more of the plurality of layers is initiated by a predetermined wavelength, the predetermined wavelength being provided by the laser.
16. The method of clause 13, wherein the energy from the laser has a substantially uniform fluence.
17. A system for forming a photovoltaic cell, the system comprising:
   a photovoltaic cell positioning mechanism, the photovoltaic cell positioning mechanism being configured for positioning a plurality of layers of the photovoltaic cell;
   a laser positioning mechanism configured for directing energy from a laser to the plurality of layers to form a scribe by selective removal of one or more of the plurality of layers;
   the laser;
   wherein the scribe is delineated from the plurality of layers by sidewalls,
   wherein at least a portion of the sidewalls includes material properties substantially consistent with the plurality of layers.
18. The system of clause 17, wherein substantially all portions of the sidewalls include material properties substantially consistent with the plurality of layers.
19. The system of clause 17, wherein the a portion of the sidewalls has been exposed to a predetermined wavelength, the predetermined wavelength being provided by the laser.
20. The system of clause 17, wherein the energy from the laser has a substantially uniform fluence.

## Claims

1. A photovoltaic cell (107), comprising:
a plurality of layers;
a scribe (503) disposed within the plurality of layers; and
sidewalls (510) delineating the scribe (503) from the plurality of layers;
wherein at least a portion of the sidewalls (510) includes material properties substantially consistent with the plurality of layers.

2. The cell (107) of claim 1, wherein the plurality of layers includes a superstrate (201), a first conductive layer (203), a buffer layer (205), a first semiconductor layer (207), a second semiconductor layer (209), a second conductive layer (211), and an encapsulating glass (213).

3. The cell (107) of claim 1 or claim 2, wherein substantially all portions of the sidewalls (510) include material properties substantially consistent with the plurality of layers.

4. The cell (107) of any preceding claim, wherein the material properties include hardness.

5. The cell (107) of any preceding claim wherein the material properties include crystal structure.

6. The cell (107) of any one of claims 2 to 5, wherein the scribe (503) extends through the first semiconductor layer (207) and the second semiconductor layer (209).

7. The cell (107) of any one of claims 2 to 5, wherein the scribe (503) extends through the buffer layer (205), the first semiconductor layer (207), the second semiconductor layer (209), and the second conductive layer (211).

8. The cell (107) of any preceding claim, wherein the a portion of the sidewalls (510) has been exposed to a predetermined wavelength, the predetermined wavelength being provided by the laser.

9. The cell (107) of any preceding claim, wherein a heat affected zone extends to less than a predetermined point, the predetermined point being 20 microns from the scribe (503).

10. The cell (107) of any preceding claim, wherein a heat affected zone extends to less than a predetermined point, the predetermined point being the sidewalls (510).

11. A method of forming a photovoltaic cell (107), the method comprising:
providing a plurality of layers; and
directing energy from a laser to the plurality of layers and selectively removing one or more of the plurality of layers to form a scribe (503);
wherein the scribe (503) is delineated from the plurality of layers by sidewalls (510),
wherein at least a portion of the sidewalls (510) includes material properties substantially consistent with the plurality of layers.

12. The method of claim 11, wherein substantially all portions of the sidewalls (510) include material properties substantially consistent with the plurality of layers.

13. The method of claim 11 or claim 12, wherein the removal of the one or more of the plurality of layers is initiated by a predetermined wavelength, the predetermined wavelength being provided by the laser.

14. The method of claim 11, wherein the energy from the laser has a substantially uniform fluence.

15. A system (700) for forming a photovoltaic cell, the system comprising:
a photovoltaic cell positioning mechanism (702), the photovoltaic cell positioning mechanism being configured for positioning a plurality of layers of the photovoltaic cell;
a laser positioning mechanism (704) configured for directing energy from a laser (706) to the plurality of layers to form a scribe (703) by selective removal of one or more of the plurality of layers;
the laser (706);
wherein the scribe (703) is delineated from the plurality of layers by sidewalls,
wherein at least a portion of the sidewalls includes material properties substantially consistent with the plurality of layers.
